(19) Europäisches Patentamt
European Patent Office
Office européen des brevets

(11) **EP 3 114 768 B1**

(12) **EUROPÄISCHE PATENTSCHRIFT**

(45) Veröffentlichungstag und Bekanntmachung des Hinweises auf die Patenterteilung:
**07.07.2021 Patentblatt 2021/27**

(21) Anmeldenummer: **15703928.0**

(22) Anmeldetag: **02.02.2015**

(51) Int Cl.:
*H04B 1/16* (2006.01)          *H04B 1/30* (2006.01)
*H04L 27/227* (2006.01)          *H03D 3/00* (2006.01)

(86) Internationale Anmeldenummer:
**PCT/EP2015/052060**

(87) Internationale Veröffentlichungsnummer:
**WO 2015/132026 (11.09.2015 Gazette 2015/36)**

(54) **DARC-SIGNAL-DEMODULATIONS-SCHALTUNGSANORDNUNG UND VERFAHREN ZU IHREM BETREIBEN**

DARC SIGNAL DEMODULATION CIRCUIT ARRANGEMENT AND METHOD FOR OPERATING SAME

CIRCUIT DE DÉMODULATION DE SIGNAL DARC ET PROCÉDÉ D'UTILISATION DE CELUI-CI

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **06.03.2014 DE 102014204151**

(43) Veröffentlichungstag der Anmeldung:
**11.01.2017 Patentblatt 2017/02**

(73) Patentinhaber: **Robert Bosch GmbH**
**70442 Stuttgart (DE)**

(72) Erfinder: **NYENHUIS, Detlev**
**31079 Sibbesse (DE)**

(56) Entgegenhaltungen:
**US-A- 4 827 515     US-A- 5 507 024**

**Beschreibung**

Stand der Technik

Aus der Druckschrift (D1) US 5 507 024 A ist ein FM-Radio-Datensystem-Stereo-Rundfunkempfänger bekannt, auch als RDS-Empfänger bezeichnet. Der Empfänger umfasst eine Eingangsstufe mit einem FM-Diskriminator, der ein zusammengesetztes Signal erzeugt, bestehend aus einem AM-Stereosignal einschließlich einer 19 kHz-Pilotschwingung und einem AM-Digital-Datensignal. Eine phasenverriegelte Schleife mit zweifacher Bandbreite verriegelt auf die Pilotschwingung und dient sowohl als Decoder des Stereoanteils des zusammengesetzten Signals als auch als Erzeugungsstufe für eine starke, stabile 38 kHz-Trägerschwingung zum Gebrauch in der Wiederaufbereitung des Bitratentaktsignals und zum Decodieren des Datensymbolsignals des Digitaldatenanteils des zusammengesetzten Signals. Vorteile umfassen die Wirtschaftlichkeit des Schaltungsaufbaus, ein einfacheres und kostengünstigeres Hochpassfilter sowie eine größere Zuverlässigkeit bei der Decodierung des Datensignals.

Eine DARC-Signal-Demodulationsschaltungsanordnung ist in dieser Druckschrift nicht erwähnt.

Aus der Druckschrift (D2) US 4 827 515 A ist ein digitaler Demodulator bekannt, der die einzelnen Bestandteile eines digitalisierten Stereo-Multiplexsignals, das einen schmalbandigen Informationskanal beim Dreifachen der Pilottonfrequenz, d.h. ein Radio-Datensignal (RDS), enthält, demoduliert und trennt. Die Demodulation wird erreicht mittels fünf digitaler Demodulatoren, denen jeweilige Trägerschwingungen aus einem Trägerschwingungs-Formungsschaltkreis zugeführt werden. Jede der Trägerschwingungen weist eine der Pilottonfrequenz, ihrem zwei- oder dreifachen entsprechende Frequenz auf. Die Trägerschwingungen werden als Datenwortfolgen erzeugt, die nur die Werte +1, -1 und 0 enthalten. Das Abtastintervall für vier der Trägerschwingungen beträgt 90°, und das Abtastintervall für die übrige Trägerschwingung beträgt 60°, beginnend bei 0°. Die Signalabtastfrequenzen sind mittels Frequenzverringerungsschaltkreisen, auch als Dezimierungsschaltkreise bezeichnet, an die unterschiedlichen Abtastfrequenzen der Trägerschwingungen angepasst. Jede der sechs Komponenten ist durch ein Tiefpassfilter von Störungen benachbarter Signale befreit.

Eine DARC-Signal-Demodulationsschaltungsanordnung ist auch in dieser Druckschrift nicht erwähnt.

Offenbarung der Erfindung

Die Erfindung hat die Aufgabe, eine DARC-Signal-Demodulations-Schaltungsanordnung, insbesondere in einem FM-Multiplex-Rundfunkempfänger, zum Rückgewinnen von DARC-Daten aus einem FM-Multiplex-Übertragungssignal und ein Verfahren zum Betreiben dieser DARC-Signal-Demodulations-Schaltungsanordnung zu verbessern und zu vereinfachen.

Diese Aufgabe wird gelöst durch eine DARC-Signal-Demodulations-Schaltungsanordnung, insbesondere in einem FM-Multiplex-Rundfunkempfänger, zum Rückgewinnen eines DARC-Daten enthaltenden DARC-Signals aus einem FM-Multiplex-Übertragungssignal. Diese DARC-Signal-Demodulations-Schaltungsanordnung umfasst einen zum Gewinnen einer ersten und einer zweiten zueinander orthogonalen, zu einem vom FM-Multiplex-Übertragungssignal umfassten Stereo-Pilotton synchronen Schwingung eingerichteten Pilotton-Regelkreis, eine Frequenz-Vervierfachungsstufe zum Gewinnen einer dritten und einer vierten zueinander orthogonalen Schwingung mit gegenüber dem Stereo-Pilotton vervierfachter Frequenz, eine erste Multiplikationsstufe zum Gewinnen eines ersten Multiplikationssignals aus dem FM-Multiplex-Übertragungssignal und der dritten Schwingung, eine zweite Multiplikationsstufe zum Gewinnen eines zweiten Multiplikationssignals aus dem FM-Multiplex-Übertragungssignal und der vierten Schwingung, ein erstes Tiefpassfilter zum Gewinnen einer ersten DARC-Signalkomponente durch Tiefpassfiltern des ersten Multiplikationssignals, ein zweites Tiefpassfilter zum Gewinnen einer zweiten DARC-Signalkomponente durch Tiefpassfiltern des zweiten Multiplikationssignals und eine FM-Demodulationsstufe zum Gewinnen des DARC-Signals aus einer Frequenzdemodulation der ersten und zweiten DARC-Signalkomponente.

Dabei ist der Begriff frequenzmoduliert hier wie üblich als FM abgekürzt. Bei dem FM-Multiplex-Übertragungssignal handelt es sich um ein Rundfunksignal, bevorzugt ein Stereo-Rundfunksignal, dem ein zusätzliches, Daten enthaltendes Signal insbesondere nach dem sogenannten L-MSK-Verfahren (Level control Minimum frequency Shift Keying) überlagert ist. Dieses Daten enthaltende Signal nach dem DARC-System, als DARC-Signal bezeichnet, ist dem Rundfunksignal auf einer Hilfsträgerschwingung von 76 KHz dadurch aufmoduliert, dass die Hilfsträgerschwingung jeweils für die Dauer einer Schwingungsperiode eines 16 kHz-Taktsignals je nach zu übertragenden Daten wahlweise auf 72 kHz oder auf 80 kHz umgeschaltet wird. Das DARC-Signal und die übrigen Anteile des Rundfunksignals, wie Mono-Audiosignal, als Hilfsträgerschwingung von 19 kHz vorliegender Stereo-Pilotton, Stereo-Differenzsignal und RDS-Signal, bilden überlagert das FM-Multiplex-Übertragungssignal. Dieses kann in analoger Form vorliegen; bevorzugt wird aber eine digitalisierte Form des FM-Multiplex-Übertragungssignals behandelt, das eine Abtastrate von wenigstens 200 kHz und eine Auflösung von z.B. 16 Bit aufweist.

Der Pilotton-Regelkreis ist eingerichtet zum Zuführen des FM-Multiplex-Übertragungssignals und zum Einregeln auf den darin als Hilfsträgerschwingung von 19 kHz vorliegenden Stereo-Pilotton. Die sich an den Pilotton-Regelkreis anschließende Frequenz-Vervierfachungsstufe umfasst eine Schaltungsanordnung zur Frequenzvervielfachung, hier insbesondere -vervierfachung, die vorteilhaft aus einer Anwendung von Sinus- bzw. Cosinus-Additionstheoremen gestaltet ist, nach denen Sinus bzw. Cosinus eines Vielfachen eines bestimmten Arguments sich aus Produkten und Summen von Sinus bzw. Cosinus dieses Arguments berechnen.

Das erste und/oder zweite Tiefpassfilter zum Filtern des ersten bzw. zweiten Multiplikationssignals dient dem Unterdrücken unerwünschter und nicht benötigter Oberschwingungen, die bei der Signalmultiplikation gebildet werden. Bevorzugt sind diese Tiefpassfilter in ihrer Grenzfrequenz einstellbar ausgebildet. Besonders bevorzugt ist eine Einstellbarkeit der Grenzfrequenz im Bereich von ca. 4 kHz bis ca. 16 kHz. Damit kann die Unterdrückung unerwünschter und an dieser Stelle störender Signalanteile optimal gewählt werden.

Die Erfindung ermöglicht eine einfache und präzise arbeitende Schaltungsanordnung zum Gewinnen des DARC-Signals, insbesondere bei Verarbeitung digitalisierter FM-Multiplex-Übertragungssignale, in hoher Signalqualität, d.h. mit hoher Signalamplitude und hohem Rauschabstand. Besonders vorteilhaft ist dabei ein FM-Demodulator in beliebiger, üblicher, bekannter Bauform einsetzbar, wodurch sich ein sehr einfacher, zuverlässiger Aufbau ergibt.

Vorteilhafte Ausgestaltungen der erfindungsgemäßen DARC-Signal-Demodulations-Schaltungsanordnung sind in den darauf rückbezogenen Unteransprüchen gekennzeichnet.

Gemäß einer bevorzugten Weiterbildung der erfindungsgemäßen DARC-Signal-Demodulations-Schaltungsanordnung ist der Pilotton-Regelkreis mit einer auf den Stereo-Pilotton zu verrastenden phasenverriegelten Schleife ausgebildet. Die Ausgestaltung mit einer phasenverriegelten Schleife (abgekürzt: PLL) gewährleistet eine genaue, stabile, zuverlässige Arbeitsweise bei einfachem Schaltungsaufbau.

Bei einer weiteren bevorzugten Ausführungsform der erfindungsgemäßen DARC-Signal-Demodulations-Schaltungsanordnung ist eine mit dem Pilotton-Regelkreis gekoppelte Taktsignal-Ableitungsstufe vorgesehen zum zu dem Stereo-Pilotton frequenz- und phasengenauen Ableiten eines Taktsignals für ein Gewinnen der DARC-Daten aus dem DARC-Signal. Diese Ausführung ermöglicht auf einfache Weise eine sehr genaue Ableitung des Taktsignals nach Frequenz und Phase, d.h. eine sehr genaue Einhaltung der gewünschten Frequenz und Phase des Taktsignals gegenüber dem Stereo-Pilotton. Dadurch ergibt sich eine präzise Arbeitsweise auch beim der Demodulation nachfolgenden Rückgewinnen der DARC-Daten aus dem DARC-Signal und anschließender DARC-Decodierung.

Eine bevorzugte Weiterbildung der erfindungsgemäßen DARC-Signal-Demodulations-Schaltungsanordnung ist gekennzeichnet durch ein der Taktsignal-Ableitungsstufe nachgeschaltetes Laufzeitglied zum Verzögern des Taktsignals um eine vorgebbare Signallaufzeit. Das Laufzeitglied ermöglicht eine präzise Einstellung einer gewünschten Phasenlage zwischen dem dadurch verzögerten Taktsignal und dem DARC-Signal und steigert damit die Präzision bei der Rückgewinnung der DARC-Daten.

Nach einer anderen Ausführungsform der erfindungsgemäßen DARC-Signal-Demodulations-Schaltungsanordnung umfasst der Pilotton-Regelkreis eine Steuersignal-Erzeugungsstufe mit einer dritten Multiplikationsstufe zum Gewinnen eines dritten Multiplikationssignals aus dem FM-Multiplex-Übertragungssignal und der ersten Schwingung, einer vierten Multiplikationsstufe zum Gewinnen eines vierten Multiplikationssignals aus dem FM-Multiplex-Übertragungssignal und der zweiten Schwingung, einer fünften Multiplikationsstufe zum Gewinnen eines fünften Multiplikationssignals aus dem dritten und dem vierten Multiplikationssignal und einer Schwellenwertschaltung zum Bilden eines Steuersignals aus dem fünften Multiplikationssignal. Außerdem umfasst dabei der Pilotton-Regelkreis einen Schwingungsgenerator zum durch das Steuersignal gesteuerten Bilden der ersten und der zweiten Schwingung mittels Polynomapproximation. Bevorzugt sind ferner ein drittes und ein viertes Tiefpassfilter vorgesehen zum Tiefpassfiltern des dritten bzw. des vierten Multiplikationssignals vor Bilden des fünften Multiplikationssignals, um unerwünschte Oberwellenanteile im dritten bzw. vierten Multiplikationssignal vor deren Weiterverarbeitung herauszufiltern.

Somit ist ein erster Abschnitt des Pilotton-Regelkreises ausgestaltet zum Bilden des Steuersignals aus einer Signalmultiplikation des FM-Multiplex-Übertragungssignals mit der vom Pilotton-Regelkreis gebildeten ersten und zweiten Schwingung; letztere werden dazu auf die als Eingangsstufen des Pilotton-Regelkreises fungierenden dritten und vierten Multiplikationsstufen rückgekoppelt.

Die Polynomapproximation an die Sinus- und Cosinus-Funktion, zu deren Durchführen der Schwingungsgenerator ausgestaltet ist, beruht auf einer Darstellung der Winkelfunktionen durch Polynome, deren Polynomkoeffizienten z.B. aus einem Verfahren der kleinsten Fehlerquadrate ermittelt sind und damit die Sinus- und Cosinus-Funktion genauer wiedergeben als z.B. die ersten Summanden einer Potenzreihenentwicklung der genannten Winkelfunktionen. Zum Annähern der zu bildenden Winkelfunktion wird der Schwingungsgenerator zum Ausbilden eines Signalverlaufs aus den Summanden des betreffenden Polynoms lediglich in einem engen Wertebereich des Arguments der Winkelfunktion, z.B. von -0,5*pi bis +0,5*pi, wobei pi = 3,14... die Kreiszahl ist, ausgestaltet; im übrigen Wertebereich des Arguments wiederholt sich die betreffende Winkelfunktion periodisch und mit wechselndem Vorzeichen. Diese Näherungen an die Winkelfunktionen, insbesondere Sinus und Cosinus, durch Polynome mit begrenzten Anzahlen von Summanden werden auch als Polynomapproximationen bezeichnet. Damit sind Schwingungsverläufe als Annäherung an Sinus bzw. Cosinus mit verhältnismäßig geringem Aufwand hinreichend genau nachbildbar. Wird das Argument des Polynoms zeitlich verändert, liefert der Schwingungsgenerator die erste und zweite Schwingung mit dieser Zeitabhängigkeit. Insbesondere bei einer Ausgestaltung zum Verarbeiten digitalisierter Signale sind zum Bilden des zeitlich veränderlichen Arguments Schaltungsmittel vorgesehen, durch die zusätzlich zum Steuersignal ein Inkrement zum zeitlichen Verändern des Arguments sowie ein Phasenfehlerausgleich in das Bilden des Arguments einbezogen sind.

Besonders bevorzugt dient das im Pilotton-Regelkreis erzeugte Steuersignal zugleich nach einer Skalierung zum Anpassen an die abgewandelte Frequenz auch der Erzeugung des Taktsignals, so dass durch ein Nachführen dieses Steuersignals zum frequenz- und phasengenauen Regeln der ersten und zweiten Schwingung selbsttätig auch ein Nachregeln des Taktsignals bewirkt wird und somit der Pilotton-Regelkreis ohne weitere Maßnahmen auch zum Liefern des Taktsignals mit sehr genauer Einhaltung der gewünschten Frequenz und Phase gegenüber dem Stereo-Pilotton eingerichtet ist.

Unter Erzielen der voraufgehend erläuterten Vorteile wird die eingangs genannte Aufgabe ferner gelöst durch ein Verfahren zum Betreiben einer in vorstehend beschriebener Weise ausgebildeten DARC-Signal-Demodulations-Schaltungsanordnung, wobei zum Rückgewinnen eines DARC-Daten enthaltenden DARC-Signals aus einem FM-Multiplex-Übertragungssignal eine erste und eine zweite zueinander orthogonale, zu einem vom FM-Multiplex-Übertragungssignal umfassten Stereo-Pilotton synchrone Schwingung gewonnen wird, aus der ersten und der zweiten Schwingung durch eine Frequenzvervierfachung eine dritte und eine vierte zueinander orthogonale Schwingung mit gegenüber dem Stereo-Pilotton vierfacher Frequenz gewonnen wird, durch Signalmultiplikation ein erstes Multiplikationssignal aus dem FM-Multiplex-Übertragungssignal und der dritten Schwingung sowie ein zweites Multiplikationssignal aus dem FM-Multiplex-Übertragungssignal und der vierten Schwingung gewonnen wird, durch Tiefpassfiltern aus dem ersten Multiplikationssignal eine erste DARC-Signalkomponente und aus dem zweiten Multiplikationssignal eine zweite DARC-Signalkomponente gewonnen wird, und wobei das DARC-Signal aus einer Frequenzdemodulation der ersten und zweiten DARC-Signalkomponente gewonnen wird.

In einer vorteilhaften Weiterbildung des erfindungsgemäßen Verfahrens wird aus dem Stereo-Pilotton ein Taktsignal zum Gewinnen der DARC-Daten aus dem DARC-Signal zu dem Stereo-Pilotton frequenz- und phasengenau abgeleitet, wodurch eine sehr genaue Einhaltung der gewünschten Frequenz und Phase des Taktsignals gegenüber dem Stereo-Pilotton ermöglicht wird.

Die eingangs genannte Aufgabe wird außerdem gelöst durch ein Computerprogrammprodukt, das Programmteile zum Ausführen eines Verfahrens der vorstehend beschriebenen Art aufweist, durch eine maschinenlesbare, insbesondere computerlesbare, Datenstruktur, die durch ein solches Verfahren und/oder durch mindestens ein solches Computerprogrammprodukt erzeugt ist, sowie durch einen maschinenlesbaren, insbesondere computerlesbaren, Datenträger, auf dem mindestens ein solches Computerprogrammprodukt aufgezeichnet und/oder gespeichert ist und/oder auf dem mindestens eine solche Datenstruktur zum Abruf bereit gehalten ist. Der Gegenstand der Erfindung ist somit verwirklichbar sowohl durch eine individuelle Zusammenstellung einzelner schaltungstechnischer Mittel, z.B. in Form eines Analogrechners, als auch durch eine an die speziell durchzuführenden Signalverarbeitungsschritte individuell angepasste Schaltungsanordnung zum Verarbeiten digitalisierter Signale, z.B. in Form eines speziell ausgebildeten digitalen Signalprozessors.

Ausführungsbeispiele der Erfindung sind in der Zeichnung dargestellt und werden im nachfolgenden näher beschrieben, wobei übereinstimmende Elemente in allen Figuren mit denselben Bezugszeichen versehen sind und eine wiederholte Beschreibung dieser Elemente weggelassen wird. Es zeigen:

Figur 1 ein Beispiel für eine erfindungsgemäße DARC-Signal-Demodulations-Schaltungsanordnung in einer Darstellung als Übersichts-Blockschaltbild,

Figur 2 ein Beispiel für einen erfindungsgemäßen Pilotton-Regelkreis zum Einsatz in der DARC-Signal-Demodulations-Schaltungsanordnung nach Figur 1,

Figur 3 ein Beispiel für einen erfindungsgemäßen Schwingungsgenerator zum Einsatz in einem Pilotton-Regelkreis nach Figur 2, und

Figur 4 ein Beispiel für eine erfindungsgemäße Frequenz-Vervierfachungsstufe zum Einsatz in der DARC-Signal-Demodulations-Schaltungsanordnung nach Figur 1.

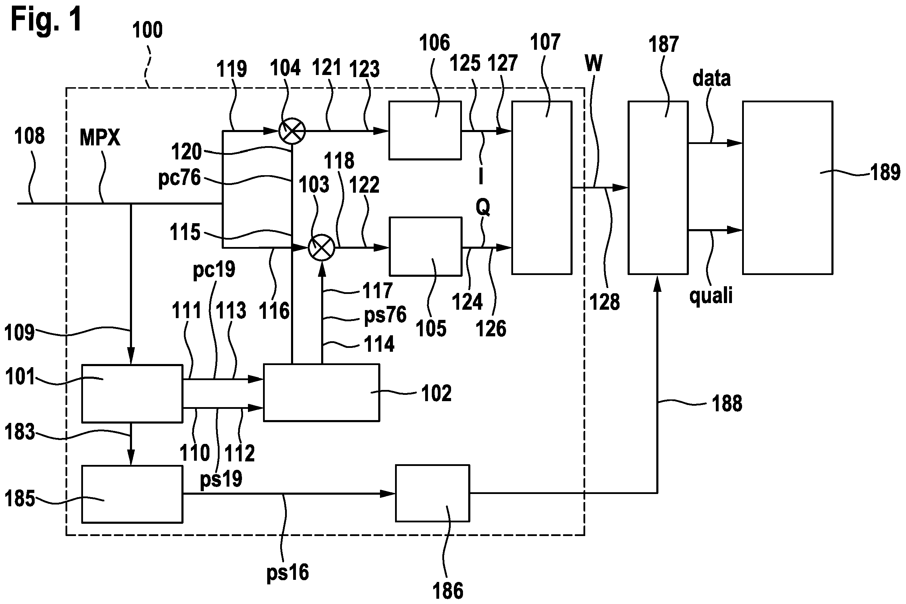

Figur 1 zeigt ein Übersichts-Blockschaltbild eines Ausführungsbeispiels einer erfindungsgemäßen DARC-Signal-Demodulations-Schaltungsanordnung 100, im Folgenden kurz als DARC-Demodulator bezeichnet, die bevorzugt zum Einsatz in einem FM-Multiplex-Rundfunkempfänger zum Rückgewinnen eines mit data bezeichnete DARC-Daten enthaltenden DARC-Signals W aus einem FM-Multiplex-Übertragungssignal MPX, kurz MPX-Signal, ausgebildet ist. Der DARC-Demodulator 100 umfasst einen Pilotton-Regelkreis 101, eine Frequenz-Vervierfachungsstufe 102, eine erste 103 und eine zweite 104 Multiplikationsstufe, ein erstes 105 und ein zweites 106 Tiefpassfilter sowie eine FM-Demodulationsstufe 107. Einem Eingangsanschluss 108 des DARC-Demodulators 100 sowie einem damit verbundenen Eingangsanschluss 109 des Pilotton-Regelkreises 101 wird im Betrieb das FM-Multiplex-Übertragungssignal MPX aus einer nicht dargestellten Rundfunk-Empfangsstufe von bevorzugt üblicher Bauform zugeleitet. Das MPX-Signal liegt dabei bereits im Basisband vor und umfasst einen Stereo-Pilotton, d.h. eine Hilfsträgerschwingung mit einer Frequenz von 19 kHz. Diese wird auch dem Pilotton-Regelkreis 101 an ihrem Eingang 109 zugeführt. Der Pilotton-Regelkreis 101 ist dazu eingerichtet, auf den Stereo-Pilotton von 19 kHz einzuregeln und zu verrasten und schwingt somit synchron zum Stereo-Pilotton von 19 kHz. Im Pilotton-Regelkreis werden eine mit ps19 bezeichnete erste und eine mit pc19 bezeichnete zweite zum Stereo-Pilotton synchrone, zueinander orthogonale, d.h. gegeneinander um 90° phasenverschobene Schwingung gewonnen und an einem ersten bzw. einem zweiten Ausgangsanschluss 110 bzw. 111 abgegeben. Die erste und die zweite Schwingung ps19, pc19 werden einem ersten bzw. einem zweiten Eingangsanschluss 112 bzw. 113 der Frequenz-Vervierfachungsstufe 102 zugeführt. In der Frequenz-Vervierfachungsstufe 102 werden aus der ersten und der zweiten Schwingung ps19, pc19 eine dritte ps76 und eine vierte pc76 zueinander orthogonale Schwingung mit gegenüber dem Stereo-Pilotton von 19 kHz vervierfachter Frequenz, d.h. von 76 kHz, gewonnen. Die dritte Schwingung ps76 wird an einem ersten Ausgangsanschluss 114, die vierte Schwingung pc76 an einem zweiten Ausgangsanschluss 115 der Frequenz-Vervierfachungsstufe 102 abgegeben.

Der ersten Multiplikationsstufe 103 wird an ihrem ersten Eingangsanschluss 116 das MPX-Signal und an ihrem zweiten Eingangsanschluss 117 die dritte Schwingung ps76 zugeführt. Durch Signalmultiplikation wird aus diesen beiden Signalen ein erstes Multiplikationssignal gewonnen und von der ersten Multiplikationsstufe 103 an einem Ausgangsanschluss 118 abgegeben. In gleicher Weise wird der zweiten Multiplikationsstufe 104 wird an ihrem ersten Eingangsanschluss 119 das MPX-Signal und an ihrem zweiten Eingangsanschluss 120 die vierte Schwingung pc76 zugeführt und wird durch Signalmultiplikation aus diesen beiden Signalen ein zweites Multiplikationssignal gewonnen und von der zweiten Multiplikationsstufe 104 an einem Ausgangsanschluss 121 abgegeben. Das erste Multiplikationssignal wird vom Ausgangsanschluss 118 der ersten Multiplikationsstufe 103 einem Eingangsanschluss 122 des ersten Tiefpassfilters 105 und das zweite Multiplikationssignal wird vom Ausgangsanschluss 121 der zweiten Multiplikationsstufe 104 einem Eingangsanschluss 123 des zweiten Tiefpassfilters 106 zugeführt. In den Tiefpassfiltern 105 bzw. 106 werden die Multiplikationssignale tiefpassgefiltert und dadurch aus dem ersten Multiplikationssignal eine erste DARC-Signalkomponente Q und aus dem zweiten Multiplikationssignal eine zweite DARC-Signalkomponente I gewonnen und an Ausgangsanschlüssen 124 bzw. 125 des ersten bzw. zweiten Tiefpassfilters 105 bzw. 106 abgegeben. Von dort werden die DARC-Signalkomponenten Q bzw. I Eingangsanschlüssen 126 bzw. 127 der FM-Demodulationsstufe 107 zugeführt. In der FM-Demodulationsstufe 107 wird aus einer Frequenzdemodulation der ersten und zweiten DARC-Signalkomponente Q und I das DARC-Signal W gewonnen und am Ausgangsanschluss 128 der FM-Demodulationsstufe 107 abgegeben, der zugleich einen Ausgangsanschluss des DARC-Demodulators 100 bildet. Die Frequenzdemodulation wird bevorzugt in üblicher Weise ausgeführt und dadurch aus den komplexen DARC-Signalkomponenten I und Q ein Phasenwinkel des DARC-Signals W bestimmt.

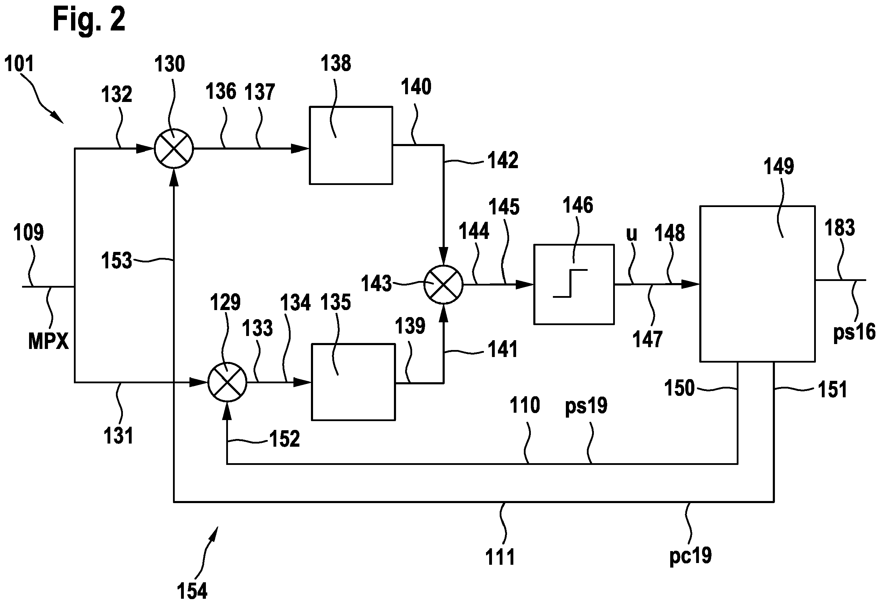

Das Beispiel für einen erfindungsgemäßen Pilotton-Regelkreis 101 in Figur 2 zum Einsatz im DARC-Demodulator nach Figur 1 ist mit einer auf den Stereo-Pilotton zu verrastenden phasenverriegelten Schleife ausgebildet, wodurch eine genaue, stabile Arbeitsweise sowie ein einfacher Aufbau erhalten werden, und umfasst dazu eine dritte 129 und eine vierte 130 Multiplikationsstufe, deren je erste Eingangsanschlüsse 131 bzw. 132 mit dem Eingangsanschluss 109 verbunden sind zum Zuführen des MPX-Signals. Ein Ausgangsanschluss 133 der dritten Multiplikationsstufe 129 ist mit einem Eingangsanschluss 134 eines dritten Tiefpassfilters 135 verbunden, und ein Ausgangsanschluss 136 der vierten Multiplikationsstufe 130 ist mit einem Eingangsanschluss 137 eines vierten Tiefpassfilters 138 verbunden. Ausgangsanschlüsse 139 bzw. 140 des dritten 135 bzw. vierten 138 Tiefpassfilters sind mit einem ersten 141 bzw. zweiten 142 Eingangsanschluss einer fünften Multiplikationsstufe 143 verbunden, deren Ausgangsanschluss 144 mit einem Eingangsanschluss 145 einer Schwellenwertschaltung 146 verbunden ist. Die Multiplikationsstufen 129, 130, 143, die Tiefpassfilter 135, 138 sowie die Schwellenwertschaltung 146 bilden zusammen eine Steuersignal-Erzeugungsstufe 154. Ein Ausgangsanschluss 147 der Schwellenwertschaltung 146 ist mit einem Eingangsanschluss 148 eines Schwingungsgenerators 149 verbunden. Dieser weist einen ersten 150 und einen zweiten 151 Ausgangsanschluss auf, die mit je einem zweiten Eingangsanschluss 152 bzw. 153 der dritten 129 bzw. vierten 130 Multiplikationsstufe verbunden sind, wodurch die Rückkopplung der phasenverriegelten Schleife gebildet ist. Die Ausgangsanschlüsse 150, 151 bilden außerdem die Ausgangsanschlüsse 110 bzw. 111 des Pilotton-Regelkreises 101.

Vom Schwingungsgenerator 149 werden die erste und die zweite Schwingung ps19, pc19 erzeugt und an den Ausgangsanschlüssen 150, 151 abgegeben. Aus einer Signalmultiplikation der ersten bzw. zweiten Schwingung ps19, pc19 mit dem MPX-Signal in der dritten bzw. vierten Multiplikationsstufe 129, 130 werden ein drittes bzw. ein viertes Multiplikationssignal gewonnen, diese zum Unterdrücken von Oberschwingungen tiefpassgefiltert und danach in der fünften Multiplikationsstufe 143 zum fünften Multiplikationssignal verknüpft, aus dem in der Schwellenwertschaltung 146 ein Steuersignal u mit abwechselnd den Werten +1 und -1 gebildet wird, das am Ausgangsanschluss 147 an den Eingangsanschluss 148 des Schwingungsgenerators 149 zum durch das Steuersignal u gesteuerten Bilden der ersten und der zweiten Schwingung ps19, pc19 abgegeben wird.

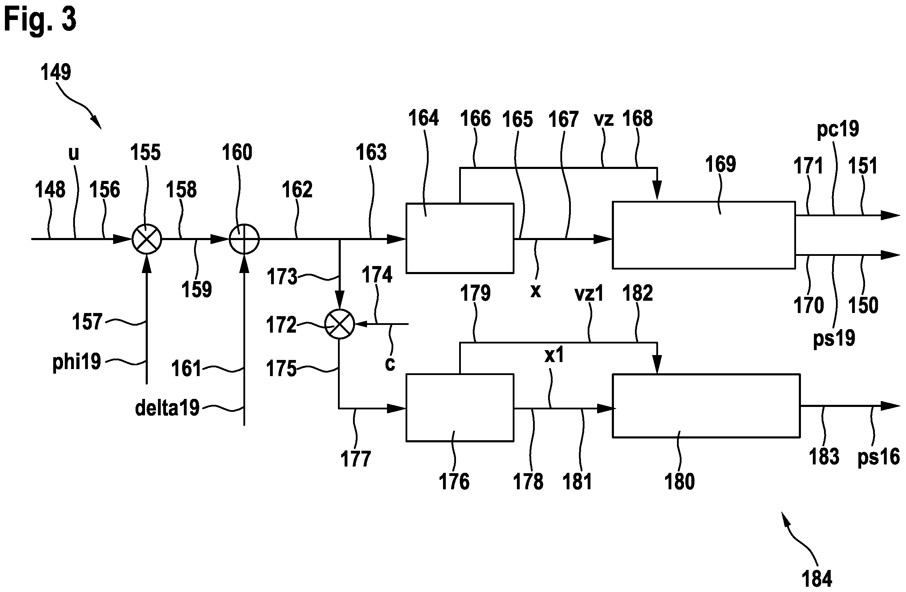

Figur 3 zeigt ein Beispiel für einen erfindungsgemäßen Schwingungsgenerator 149 zum Einsatz in einem Pilotton-Regelkreis 101 nach Figur 2. Darin ist eine sechste Multiplikationsstufe 155 umfasst, deren erster Eingangsanschluss 156 mit dem Eingangsanschluss 148 verbunden ist und an dessen zweitem Eingangsanschluss 157 im Betrieb ein Phasenfehler-Ausgleichssignal phi19 anliegt. Ein Ausgangsanschluss 158 der sechsten Multiplikationsstufe 155 ist mit einem ersten Eingangsanschluss 159 einer Additionsstufe 160 verbunden, an deren zweitem Eingangsanschluss 161 im Betrieb ein Inkrementsignal delta19 anliegt. Ein Ausgangsanschluss 162 der Additionsstufe 160 ist an einen Eingangsanschluss 163 einer ersten Integrationsstufe 164 angeschlossen, die an einem Argumentausgangsanschluss 165 mit einem Argumenteingangsanschluss 167 und an einem Überlaufausgangsanschluss 166 mit einem Vorzeicheneingangsanschluss 168 einer ersten Polynomstufe 169 verbunden ist. Ein erster 170 und ein zweiter 171 Ausgangsanschluss der ersten Polynomstufe 169 sind zum Abgeben der ersten ps19 bzw. zweiten pc19 Schwingung eingerichtet und bilden zugleich den ersten 150 bzw. zweiten 151 Ausgangsanschluss des Schwingungsgenerators 149.

Von der sechsten Multiplikationsstufe 155 wird durch Signalmultiplikation des Steuersignals u mit dem Phasenfehler-Ausgleichssignal phi19 ein sechstes Multiplikationssignal gewonnen, das in der Additionsstufe 160 zum Inkrementsignal delta19 addiert und dadurch ein Summensignal erzeugt wird, das in der ersten Integrationsstufe 164 integriert wird. Die erste Integrationsstufe arbeitet im sogenannten "wrap mode", d.h. sie weist einen begrenzten Signalwertebereich auf, in dem der Signalwert am Argumentausgangsanschluss 165 liegt. Beim Überlauf über eine der Grenzen des Signalwertebereichs wird das Ergebnis von der anderen Grenze an weitergezählt. Reicht z.B. der Signalwertebereich von -1 bis +1, ergibt eine derartige Addition z.B. 0,8 + 0,3 = -0,9. Am Überlaufausgangsanschluss 166 wird ein Vorzeichensignal vz abgegeben, das bei jedem Überlauf der Integrationsstufe 164 zwischen den Werten +1 und -1 umschaltet. Aus diesen Signalwerten am Argumentausgangsanschluss 165 und dem Vorzeichensignal vz werden in der ersten Polynomstufe 169 Signalwerte für die erste und zweite Schwingung ps19, pc19 durch eine Polynomapproximation erzeugt, bei der die Winkelfunktionen Sinus und Cosinus durch Polynome angenähert dargestellt werden gemäß

$$ps19 = \sin(x) = vz * (a1 * x + a3 * x^3 + a5 * x^5)$$

und

$$pc19 = \cos(x) = vz * (1 + a2 * x^2 + a4 * x^4) \quad,$$

mit:

$$x = 2 * pi * 19\text{kHz} * t \quad,$$

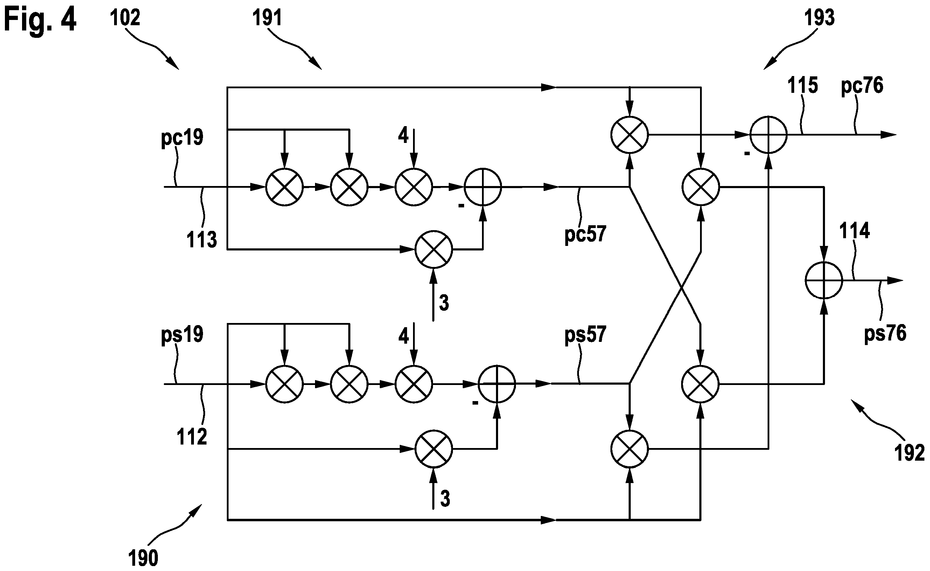

wobei pi die Kreiszahl, t die Zeit und a1 bis a5 Koeffizienten der Polynomapproximationen sind. Eine nähere Beschreibung einer derartigen Polynomapproximation ist in der EP 0 627 834 A1, insbesondere Figuren 4 und 5, gegeben, auf deren Offenbarung hiermit ausdrücklich Bezug genommen ist.

Der Ausgangsanschluss 162 der Additionsstufe 160 ist ferner mit einem ersten Eingangsanschluss 173 einer siebten Multiplikationsstufe 172 verbunden, der im Betrieb an einem zweiten Eingangsanschluss 174 ein Skalierungssignal c mit dem Signalwert 16/19 zugeführt wird. Ein in der siebten Multiplikationsstufe 172 durch Signalmultiplikation aus dem Summensignal und dem Skalierungssignal c gebildetes siebtes Multiplikationssignal wird von einem Ausgangsanschluss 175 der siebten Multiplikationsstufe 172 an einen Eingangsanschluss 177 einer in Aufbau und Betriebsweise mit der ersten Integrationsstufe 164 identischen zweiten Integrationsstufe 176 abgegeben und in letzterer integriert. An einem Überlaufausgangsanschluss 179 wird ein Vorzeichensignal vzl abgegeben, das bei jedem Überlauf der zweiten Integrationsstufe 176 zwischen den Werten +1 und - 1 umschaltet. Aus den Signalwerten an einem Argumentausgangsanschluss 178 und dem Vorzeichensignal vzl werden in einer der zweiten Integrationsstufe 176 nachgeschalteten zweiten Polynomstufe 180 Signalwerte für ein Taktsignal ps16 durch eine Polynomapproximation erzeugt, bei der die Winkelfunktion Sinus durch ein Polynom angenähert dargestellt wird gemäß

$$ps16 = \sin(x1) = vz1 * (a1 * x1 + a3 * x1^3 + a5 * x1^5) \quad,$$

mit

$$x1 = 2 * pi * 16\text{kHz} * t \quad.$$

Durch Skalierung mit dem Skalierungssignal c wird der zweiten Integrationsstufe 176 ein gegenüber dem Summensignal am Eingangsanschluss 163 der ersten Integrationsstufe 164 um den Faktor 16/19 verringertes Inkrement zugeführt und daraus das Taktsignal ps16 mit einer Frequenz von 16 kHz frequenz- und phasengenau zum Stereo-Pilotton erzeugt, so dass Nachführen des Steuersignals u zum frequenz- und phasengenauen Regeln der ersten und zweiten Schwingung ps19, pc19 selbsttätig auch ein Nachregeln des Taktsignals ps16 bewirkt, und an einem Ausgangsanschluss 183 der zweiten Polynomstufe 180 abgegeben. Das ermöglicht ein einfaches und genaues Ableiten und Einhalten der gewünschten Frequenz und Phase des Taktsignals ps16 im Vergleich zum Stereo-Pilotton und ergibt eine präzise Funktionsweise auch beim nachfolgenden Rückgewinnen der DARC-Daten data aus dem DARC-Signal W und bei einer nachfolgender DARC-Decodierung. Die zweite Integrationsstufe 176 und die zweite Polynomstufe 180 bilden zusammen eine mit dem Pilotton-Regelkreis 101 gekoppelte Taktsignal-Ableitungsstufe 184.

Mit dem Ausgangsanschluss 183 der zweiten Polynomstufe 180 ist eine Taktsignalformstufe 185 verbunden zum Formen des Taktsignals, z.B. zum Glätten bzw. Tiefpassfiltern des zeitlichen Verlaufs desselben. Über ein Laufzeitglied 186 mit bevorzugt einstellbarer Signallaufzeit zum genauen Anpassen der Phasenlage zwischen Taktsignal ps16 und DARC-Signal W wird das Taktsignal für ein Gewinnen der DARC-Daten data aus dem DARC-Signal W einer DARC-Datenrückgewinnungsstufe 187 zugeleitet, deren Takteingang 188 über das Laufzeitglied 186 mit der Taktsignalformstufe 185 verbunden ist. In der DARC-Datenrückgewinnungsstufe 187 wird außer den DARC-Daten data auch ein Qualitätssignal quali gewonnen. Dazu wird das demodulierte DARC-Signal W während der Dauer einer Periode des Taktsignals ps16 in einem Kurzzeitintegrator aufsummiert, das Ergebnis mit einem Signal-Schwellenwert verglichen und daraus der aktuelle Wert des zu erkennenden Datenbits der DARC-Daten data bestimmt. Durch einen entsprechenden Vergleich des Kurzzeitintegrationsergebnisses mit einem Qualitäts-Schwellenwert wird das Qualitätssignal quali für jedes Bit der DARC-Daten data ermittelt und damit eine Aussage über die Signal-, d.h. Empfangsqualität und damit die Verlässlichkeit der DARC-Daten data getroffen. DARC-Daten data und Qualitätssignal quali werden einem mit der DARC-Datenrückgewinnungsstufe 187 verbundenen DARC-Decoder 189 zur weiteren Verarbeitung zugeführt.

Figur 4 zeigt ein Beispiel für eine erfindungsgemäße Frequenz-Vervierfachungsstufe 102 zum Einsatz im DARC-Demodulator 100 nach Figur 1. Darin wird die Frequenzvervierfachung durch eine Anwendung folgender Sinus- bzw. Cosinus-Additionstheoreme vorgenommen:

$$ps57 = \sin(2 * pi * 57\text{kHz} * t) = \sin(3 * 2 * pi * 19\text{kHz} * t) = 3 * ps19 - 4 * (ps19)^3$$

$$pc57 = \cos(2 * pi * 57\text{kHz} * t) = \cos(3 * 2 * pi * 19\text{kHz} * t) = 4 * (pc19)^3 - 3 * pc19$$

und

$$ps76 = \sin(2 * pi * 76\text{kHz} * t) = ps19 * pc57 + pc19 * ps57$$

$$pc76 = \cos(2 * pi * 76\text{kHz} * t) = pc19 * pc57 - ps19 * ps57$$ .

Dabei sind ps57 und pc57 erste bzw. zweite Signale, die sich als Zwischenergebnisse bei der Signalgewinnung unter Anwendung der Additionstheoreme ergeben. Im einzelnen wird in einer ersten Stufe 190 der Frequenz-Vervierfachungsstufe 102 gemäß der ersten der vorstehenden Gleichungen in zwei einander nachgeschaleten Multiplizierstufen die erste Schwingung ps19 zur dritten Potenz erhoben und in einer Multiplizierstufe mit einem konstanten Faktor mit dem Wert 4 multipliziert, außerdem die erste Schwingung ps19 in einer Multiplizierstufe mit einem konstanten Faktor mit dem Wert 3 multipliziert und beide derart gewonnenen Signale in einer Subtrahierstufe voneinander subtrahiert und damit das erste Zwischenergebnis-Signal ps57 erhalten. In gleicher Art wird in einer zweiten Stufe 191 der Frequenz-Vervierfachungsstufe 102 gemäß der zweiten der vorstehenden Gleichungen in zwei einander nachgeschaleten Multiplizierstufen die zweite Schwingung pc19 zur dritten Potenz erhoben und in einer Multiplizierstufe mit einem konstanten Faktor mit dem Wert 4 multipliziert, außerdem die zweite Schwingung pc19 in einer Multiplizierstufe mit einem konstanten Faktor mit dem Wert 3 multipliziert und beide derart gewonnenen Signale in einer Subtrahierstufe voneinander subtrahiert und damit das zweite Zwischenergebnis-Signal pc57 erhalten. In einer nachgeschalteten dritten Stufe 192 werden in je einer Multiplizierstufe die erste Schwingung ps19 mit dem zweiten Zwischenergebnis-Signal pc57 und die zweite Schwingung pc19 mit dem ersten Zwischenergebnis-Signal ps57 multipliziert und diese Multiplikationsergebnisse in einer Addierstufe zur dritten Schwingung ps76 additiv überlagert. In einer ebenfalls nachgeschalteten vierten Stufe 193 werden in je einer Multiplizierstufe die zweite Schwingung pc19 mit dem zweiten Zwischenergebnis-Signal pc57 und die erste Schwingung ps19 mit dem ersten Zwischenergebnis-Signal ps57 multipliziert und diese Multiplikationsergebnisse in einer Subtrahierstufe zur vierten Schwingung pc76 überlagert.

**Bezugszeichenliste**

| | |
|---|---|
| 100 | DARC-Signal-Demodulations-Schaltungsanordnung (DARC-Demodulator) |
| 101 | Pilotton-Regelkreis in 100 |
| 102 | Frequenz-Vervierfachungsstufe in 100 |
| 103 | Erste Multiplikationsstufe in 100 |
| 104 | Zweite Multiplikationsstufe in 100 |
| 105 | Erstes Tiefpassfilter in 100 |
| 106 | Zweites Tiefpassfilter in 100 |
| 107 | FM-Demodulationsstufe in 100 |
| 108 | Eingangsanschluss des DARC-Demodulators 100 |
| 109 | Eingangsanschluss des Pilotton-Regelkreises 101 |
| 110 | Erster Ausgangsanschluss von 101 für ps19 |
| 111 | Zweiter Ausgangsanschluss von 101 für pc19 |
| 112 | Erster Eingangsanschluss von 102 für ps19 |
| 113 | Zweiter Eingangsanschluss von 102 für pc19 |
| 114 | Erster Ausgangsanschluss von 102 für ps76 |
| 115 | Zweiter Ausgangsanschluss von 102 für pc76 |
| 116 | Erster Eingangsanschluss von 103 für MPX |
| 117 | Zweiter Eingangsanschluss von 103 für ps76 |
| 118 | Ausgangsanschluss von 103 für erstes Multiplikationssignal |
| 119 | Erster Eingangsanschluss von 104 für MPX |
| 120 | Zweiter Eingangsanschluss von 104 für pc76 |
| 121 | Ausgangsanschluss von 104 für zweites Multiplikationssignal |
| 122 | Eingangsanschluss von 105 für erstes Multiplikationssignal |
| 123 | Eingangsanschluss von 106 für zweites Multiplikationssignal |
| 124 | Ausgangsanschluss von 105 für tiefpassgefiltertes erstes Multiplikationssignal |
| 125 | Ausgangsanschluss von 106 für tiefpassgefiltertes zweites Multiplikationssignal |
| 126 | Erster Eingangsanschluss von 107 für Q |
| 127 | Zweiter Eingangsanschluss von 107 für I |
| 128 | Ausgangsanschluss von 107 für W |
| 129 | Dritte Multiplikationsstufe in 101 |
| 130 | Vierte Multiplikationsstufe in 101 |
| 131 | Erster Eingangsanschluss von 129 für MPX |
| 132 | Erster Eingangsanschluss von 130 für MPX |
| 133 | Ausgangsanschluss von 129 für drittes Multiplikationssignal |
| 134 | Eingangsanschluss von 135 für drittes Multiplikationssignal |
| 135 | Drittes Tiefpassfilter in 101 |
| 136 | Ausgangsanschluss von 130 für viertes Multiplikationssignal |
| 137 | Eingangsanschluss von 138 für viertes Multiplikationssignal |
| 138 | Viertes Tiefpassfilter in 101 |
| 139 | Ausgangsanschluss von 135 für tiefpassgefiltertes drittes Multiplikationssignal |
| 140 | Ausgangsanschluss von 138 für tiefpassgefiltertes viertes Multiplikationssignal |
| 141 | Erster Eingangsanschluss von 143 |
| 142 | Zweiter Eingangsanschluss von 143 |
| 143 | Fünfte Multiplikationsstufe in 101 |
| 144 | Ausgangsanschluss von 143 |
| 145 | Eingangsanschluss von 146 |
| 146 | Schwellenwertschaltung von 101 |
| 147 | Ausgangsanschluss von 146 |
| 148 | Eingangsanschluss von 149 |
| 149 | Schwingungsgenerator in 101 |
| 150 | Erster Ausgangsanschluss von 149 für ps19 |
| 151 | Zweiter Ausgangsanschluss von 149 für pc19 |

EP 3 114 768 B1

| 152 | Zweiter Eingangsanschluss von 129 |
| 153 | Zweiter Eingangsanschluss von 130 |
| 154 | Steuersignal-Erzeugungsstufe von 101 (aus 129, 130, 135, 138, 143, 146) |
| 155 | Sechste Multiplikationsstufe in 149 |
| 156 | Erster Eingangsanschluss von 155 in 149 |
| 157 | Zweiter Eingangsanschluss von 155 in 149 für phi19 |
| 158 | Ausgangsanschluss von 155 in 149 für sechstes Multiplikationssignal |
| 159 | Erster Eingangsanschluss von 160 in 149 |
| 160 | Additionsstufe in 149 |
| 161 | Zweiter Eingangsanschluss von 160 in 149 für delta19 |
| 162 | Ausgangsanschluss von 160 in 149 für Summensignal |
| 163 | Eingangsanschluss von 164 in 149 für Summensignal |
| 164 | Erste Integrationsstufe in 149 |
| 165 | Argumentausgangsanschluss von 164 in 149 |
| 166 | Überlaufausgangsanschluss von 164 in 149 |
| 167 | Argumenteingangsanschluss von 169 in 149 |
| 168 | Vorzeicheneingangsanschluss von 169 in 149 |
| 169 | Erste Polynomstufe in 149 |
| 170 | Erster Ausgangsanschluss von 169 in 149 zum Abgeben von ps19 |
| 171 | Zweiter Ausgangsanschluss von 169 in 149 zum Abgeben von pc19 |
| 172 | Siebte Multiplikationsstufe in 149 |
| 173 | Erster Eingangsanschluss von 172 in 149 |
| 174 | Zweiter Eingangsanschluss von 172 in 149 |
| 175 | Ausgangsanschluss von 172 in 149 für siebtes Multiplikationssignal |
| 176 | Zweite Integrationsstufe in 149 |
| 177 | Eingangsanschluss von 176 in 149 für siebtes Multiplikationssignal |
| 178 | Argumentausgangsanschluss von 176 in 149 |
| 179 | Überlaufausgangsanschluss von 176 in 149 |
| 180 | Zweite Polynomstufe in 149 |
| 181 | Argumenteingangsanschluss von 180 in 149 |
| 182 | Vorzeicheneingangsanschluss von 180 in 149 |
| 183 | Ausgangsanschluss von 180 in 149 zum Abgeben von ps16 |
| 184 | Taktsignal-Ableitungsstufe in 149 |
| 185 | Taktsignalformstufe |
| 186 | Laufzeitglied |
| 187 | DARC-Datenrückgewinnungsstufe |
| 188 | Takteingang von 187 |
| 189 | DARC-Decoder |
| 190 | Erste Stufe in 102 |
| 191 | Zweite Stufe in 102 |
| 192 | Dritte Stufe in 102 |
| 193 | Vierte Stufe in 102 |

| a1 | Koeffizient der Reihenentwicklung für die Sinusfunktion |
| a2 | Koeffizient der Reihenentwicklung für die Cosinusfunktion |
| a3 | Koeffizient der Reihenentwicklung für die Sinusfunktion |
| a4 | Koeffizient der Reihenentwicklung für die Cosinusfunktion |
| a5 | Koeffizient der Reihenentwicklung für die Sinusfunktion |

| c | Skalierungssignal (c = 16/19) |
| data | DARC-Daten von 187 |
| delta19 | Inkrementsignal an 161 von 160 in 149 |

| I | Zweite DARC-Signalkomponente an 124, 126 |

| MPX | FM-Multiplex-Übertragungssignal (MPX-Signal) |

| phi19 | Phasenfehler-Ausgleichssignal an 157 von 155 in 149 |

pc19    Zweite Schwingung von 19 kHz an 111 bzw. 151
pc57    Zweites Zwischenergebnis-Signal in 102
pc76    Vierte Schwingung von 76 kHz an 115
ps16    Taktsignal von 16 kHz an 183 von 180
ps19    Erste Schwingung von 19 kHz an 110 bzw. 150
ps57    Erstes Zwischenergebnis-Signal in 102
ps76    Dritte Schwingung von 76 kHz an 114

Q    Erste DARC-Signalkomponente an 125, 127
quali    Qualitätssignal von 187

t    Zeit

u    Steuersignal (u = +/-1)

vz    Vorzeichensignal an 166 von 164 (vz = +/-1)
vz1    Vorzeichensignal an 179 von 176 (vz1 = +/-1)

W    DARC-Signal

x    Argument der Winkelfunktionen (x = 2*pi*19kHz*t)
x1    Argument der Winkelfunktionen (x1 = 2*pi*16kHz*t)


**Patentansprüche**

1. DARC-Signal-Demodulations-Schaltungsanordnung (100), insbesondere in einem FM-Multiplex-Rundfunkempfänger, zum Rückgewinnen eines DARC-Daten (data) enthaltenden DARC-Signals (W) aus einem FM-Multiplex-Übertragungssignal (MPX), umfassend

   • einen zum Gewinnen einer ersten (ps19) und einer zweiten (pc19) zueinander orthogonalen, zu einem vom FM-Multiplex-Übertragungssignal (MPX) umfassten Stereo-Pilotton synchronen Schwingung eingerichteten Pilotton-Regelkreis (101),
   • eine Frequenz-Vervierfachungsstufe (102) zum Gewinnen einer dritten (ps76) und einer vierten (pc76) zueinander orthogonalen Schwingung mit gegenüber dem Stereo-Pilotton vervierfachter Frequenz,
   • eine erste Multiplikationsstufe (103) zum Gewinnen eines ersten Multiplikationssignals aus dem FM-Multiplex-Übertragungssignal (MPX) und der dritten Schwingung (ps76),
   • eine zweite Multiplikationsstufe (104) zum Gewinnen eines zweiten Multiplikationssignals aus dem FM-Multiplex-Übertragungssignal (MPX) und der vierten Schwingung (pc76),
   • ein erstes Tiefpassfilter (105) zum Gewinnen einer ersten DARC-Signalkomponente (Q) durch Tiefpassfiltern des ersten Multiplikationssignals,
   • ein zweites Tiefpassfilter (106) zum Gewinnen einer zweiten DARC-Signalkomponente (I) durch Tiefpassfiltern des zweiten Multiplikationssignals und
   • eine FM-Demodulationsstufe (107) zum Gewinnen des DARC-Signals (W) aus einer Frequenzdemodulation der ersten (Q) und zweiten (I) DARC-Signalkomponente.

2. DARC-Signal-Demodulations-Schaltungsanordnung (100) nach Anspruch 1, **dadurch gekennzeichnet, dass** der Pilotton-Regelkreis (101) mit einer auf den Stereo-Pilotton zu verrastenden phasenverriegelten Schleife ausgebildet ist.

3. DARC-Signal-Demodulations-Schaltungsanordnung (100) nach Anspruch 1 oder 2, **gekennzeichnet durch** eine mit dem Pilotton-Regelkreis (101) gekoppelte Taktsignal-Ableitungsstufe (184) zum zu dem Stereo-Pilotton frequenz- und phasengenauen Ableiten eines Taktsignals (ps16) für ein Gewinnen der DARC-Daten (data) aus dem DARC-Signal (W).

4. DARC-Signal-Demodulations-Schaltungsanordnung (100) nach Anspruch 3, **gekennzeichnet durch** ein der Taktsignal-Ableitungsstufe (184) nachgeschaltetes Laufzeitglied (186) zum Verzögern des Taktsignals (ps16) um eine vorgebbare Signallaufzeit.

**5.** DARC-Signal-Demodulations-Schaltungsanordnung (100) nach einem oder mehreren der vorhergehenden Ansprüche, **dadurch gekennzeichnet, dass** der Pilotton-Regelkreis (101) eine Steuersignal-Erzeugungsstufe (154) umfasst mit

- einer dritten Multiplikationsstufe (129) zum Gewinnen eines dritten Multiplikationssignals aus dem FM-Multiplex-Übertragungssignal (MPX) und der ersten Schwingung (ps19),
- einer vierten Multiplikationsstufe (130) zum Gewinnen eines vierten Multiplikationssignals aus dem FM-Multiplex-Übertragungssignal (MPX) und der zweiten Schwingung (pc19),
- einer fünften Multiplikationsstufe (143) zum Gewinnen eines fünften Multiplikationssignals aus dem dritten und dem vierten Multiplikationssignal und
- einer Schwellenwertschaltung (146) zum Bilden eines Steuersignals (u) aus dem fünften Multiplikationssignal,

und dass der Pilotton-Regelkreis (101) ferner einen Schwingungsgenerator (149) umfasst zum durch das Steuersignal (u) gesteuerten Bilden der ersten (ps19) und der zweiten (pc19) Schwingung mittels Polynomapproximation.

**6.** Verfahren zum Betreiben einer nach einem oder mehreren der Ansprüche 1 bis 5 ausgebildeten DARC-Signal-Demodulations-Schaltungsanordnung (100), wobei zum Rückgewinnen eines DARC-Daten (data) enthaltenden DARC-Signals (W) aus einem FM-Multiplex-Übertragungssignal (MPX)

- eine erste (ps19) und eine zweite (pc19) zueinander orthogonale, zu einem vom FM-Multiplex-Übertragungssignal (MPX) umfassten Stereo-Pilotton synchrone Schwingung gewonnen wird,
- aus der ersten (ps19) und der zweiten (pc19) Schwingung durch eine Frequenzvervierfachung eine dritte (ps76) und eine vierte (pc76) zueinander orthogonale Schwingung mit gegenüber dem Stereo-Pilotton vierfacher Frequenz gewonnen wird,
- durch Signalmultiplikation ein erstes Multiplikationssignal aus dem FM-Multiplex-Übertragungssignal (MPX) und der dritten Schwingung (ps76) sowie ein zweites Multiplikationssignal aus dem FM-Multiplex-Übertragungssignal (MPX) und der vierten Schwingung (pc76) gewonnen wird,
- durch Tiefpassfiltern aus dem ersten Multiplikationssignal eine erste DARC-Signalkomponente (Q) und aus dem zweiten Multiplikationssignal eine zweite DARC-Signalkomponente (I) gewonnen wird,
- und wobei das DARC-Signal (W) aus einer Frequenzdemodulation der ersten (Q) und zweiten (I) DARC-Signalkomponente gewonnen wird.

**7.** Verfahren nach Anspruch 6, **dadurch gekennzeichnet, dass** aus dem Stereo-Pilotton ein Taktsignal (ps16) zum Gewinnen der DARC-Daten (data) aus dem DARC-Signal (W) zu dem Stereo-Pilotton frequenz- und phasengenau abgeleitet wird.

**8.** Computerprogrammprodukt mit Anweisungen, die bewirken, dass ein System, bestehend aus der DARC-Signal-Demodulations-Schaltungsanordnung nach einem der Ansprüche 1-5 und einem Signalprozessor, das Verfahren nach einem der Ansprüche 6 oder 7 durchführt.

**9.** Maschinenlesbare, insbesondere computerlesbare, Datenstruktur, erzeugt durch ein Verfahren gemäß mindestens einem der Ansprüche 6 oder 7 und/oder durch mindestens ein Computerprogrammprodukt gemäß Anspruch 8.

**10.** Maschinenlesbarer, insbesondere computerlesbarer, Datenträger, auf dem mindestens ein Computerprogrammprodukt gemäß Anspruch 8 aufgezeichnet und/oder gespeichert ist und/oder auf dem mindestens eine Datenstruktur gemäß Anspruch 9 zum Abruf bereit gehalten ist.

**Claims**

**1.** DARC signal demodulation circuit arrangement (100), in particular in an FM multiplex radio receiver, for recovering a DARC signal (W), containing DARC data (data), from an FM multiplex transmission signal (MPX), comprising

- a pilot tone control circuit (101), which is set up to obtain a first (ps19) and a second (pcl9) oscillation, which are orthogonal with respect to one another and which are in sync with a stereo pilot tone that the FM multiplex transmission signal (MPX) comprises,
- a frequency quadrupling stage (102) for obtaining a third (ps76) and a fourth (pc76) oscillation, which are orthogonal with respect to one another, at a frequency that is quadrupled in comparison with the stereo pilot tone,
• a first multiplication stage (103) for obtaining a first multiplication signal from the FM multiplex transmission signal (MPX) and the third oscillation (ps76) ,
• a second multiplication stage (104) for obtaining a second multiplication signal from the FM multiplex transmission signal (MPX) and the fourth oscillation (pc76),
• a first low-pass filter (105) for obtaining a first DARC signal component (Q) by low-pass filtering the first multiplication signal,
• a second low-pass filter (106) for obtaining a second DARC signal component (I) by low-pass filtering the second multiplication signal and
• an FM demodulation stage (107) for obtaining the DARC signal (W) from frequency demodulation of the first (Q) and second (I) DARC signal component.

2.  DARC signal demodulation circuit arrangement (100) according to Claim 1, **characterized in that** the pilot tone control circuit (101) is configured with a phase-locked loop to be latched onto the stereo pilot tone.

3.  DARC signal demodulation circuit arrangement (100) according to Claim 1 or 2, **characterized by** a clock signal derivation stage (184), which is coupled to the pilot tone control circuit (101), for deriving, in a frequency-accurate and phase-accurate manner with respect to the stereo pilot tone, a clock signal (ps16) for obtaining the DARC data (data) from the DARC signal (W).

4.  DARC signal demodulation circuit arrangement (100) according to Claim 3, **characterized by** a propagation time element (186), which is connected downstream of the clock signal derivation stage (184), for delaying the clock signal (ps16) by a predefinable signal propagation time.

5.  DARC signal demodulation circuit arrangement (100) according to one or more of the preceding claims, **characterized in that** the pilot tone control circuit (101) comprises a control signal generation stage (154) having:

    • a third multiplication stage (129) for obtaining a third multiplication signal from the FM multiplex transmission signal (MPX) and the first oscillation (ps19) ,
    • a fourth multiplication stage (130) for obtaining a fourth multiplication signal from the FM multiplex transmission signal (MPX) and the second oscillation (pc19) ,
    • a fifth multiplication stage (143) for obtaining a fifth multiplication signal from the third and the fourth multiplication signal and
    • a threshold value circuit (146) for forming a control signal (u) from the fifth multiplication signal,

    and **in that** the pilot tone control circuit (101) also comprises an oscillation generator (149) for forming the first (ps19) and the second (pcl9) oscillation, in a manner controlled by the control signal (u), by means of polynomial approximation.

6.  Method for operating a DARC signal demodulation circuit arrangement (100) configured according to one or more of Claims 1 to 5, wherein, to recover a DARC signal (W), containing DARC data (data), from an FM multiplex transmission signal (MPX)

    • a first (psl9) and a second (pc19) oscillation, which are orthogonal with respect to one another and which are in sync with a stereo pilot tone that the FM multiplex transmission signal (MPX) comprises, are obtained,
    • a third (ps76) and a fourth (pc76) oscillation, which are orthogonal with respect to one another, having quadruple the frequency of the stereo pilot tone are obtained from the first (ps19) and the second (pc19) oscillation by frequency quadruplication,
    • a first multiplication signal is obtained from the FM multiplex transmission signal (MPX) and the third oscillation (ps76) by signal multiplication and
    • a second multiplication signal is obtained from the FM multiplex transmission signal (MPX) and the fourth oscillation (pc76),
    • a first DARC signal component (Q) is obtained from the first multiplication signal by low-pass filtering, and
    • a second DARC signal component (I) is obtained from the second multiplication signal,
    • and wherein the DARC signal (W) is obtained from a frequency demodulation of the first (Q) and the second (I) DARC signal component.

7.  Method according to Claim 6, **characterized in that** a clock signal (ps16) for obtaining the DARC data (data) from the DARC signal (W) is derived from the stereo pilot tone in a frequency-accurate and phase-accurate manner with respect to the stereo pilot tone.

8. Computer program product with instructions that cause a system consisting of the DARC signal demodulation circuit arrangement according to one of Claims 1-5 and a signal processor to carry out the method according to either of Claims 6 and 7.

9. Machine-readable, in particular computer-readable, data structure, produced by a method according to at least one of Claims 6 and 7 and/or by at least one computer program product according to Claim 8.

10. Machine-readable, in particular computer-readable data carrier, on which at least one computer program product according to Claim 8 is recorded and/or stored and/or on which at least one data structure according to Claim 9 is available for retrieval.

**Revendications**

1. Agencement de circuits de démodulation de signal DARC (100), en particulier dans un récepteur de radiodiffusion multiplex FM pour récupérer un signal DARC (W) contenant des données DARC (data) à partir d'un signal de transmission multiplex FM (MPX), comprenant

   • un circuit de réglage de tonalité pilote (101) aménagé pour obtenir une première (psl9) et une deuxième oscillation (pcl9), orthogonales l'une à l'autre, synchrones à une tonalité pilote stéréo contenue dans le signal de transmission multiplex FM (MPX),
   • un étage quadrupleur de fréquence (102) pour obtenir une troisième (ps76) et une quatrième (pc76) oscillation, orthogonales l'une à l'autre, ayant une fréquence quadruplée par rapport à la tonalité pilote stéréo,
   • un premier étage multiplicateur (103) pour obtenir un premier signal de multiplication à partir du signal de transmission multiplex FM (MPX) et de la troisième oscillation (ps76),
   • un deuxième étage multiplicateur (104) pour obtenir un deuxième signal de multiplication à partir du signal de transmission multiplex FM (MPX) et de la quatrième oscillation (pc76),
   • un premier filtre passe-bas (105) pour obtenir une première composante de signal DARC (Q) par filtrage passe-bas du premier signal de multiplication,
   • un deuxième filtre passe-bas (106) pour obtenir une deuxième composante de signal DARC (I) par filtrage passe-bas du deuxième signal de multiplication, et
   • un étage de démodulation FM (107) pour obtenir le signal DARC (W) à partir d'une modulation de fréquence de la première (Q) et de la deuxième (I) composante de signal DARC.

2. Agencement de circuits de démodulation de signal DARC (100) selon la revendication 1, **caractérisé en ce que** le circuit de réglage de tonalité pilote (101) est réalisé avec une boucle verrouillée en phase à verrouiller sur la tonalité pilote stéréo.

3. Agencement de circuits de démodulation de signal DARC (100) selon la revendication 1 ou 2, **caractérisé par** un étage de dérivation de signal d'horloge (184) couplé au circuit de réglage de tonalité pilote (101) pour dériver un signal d'horloge (psl6) compensé en fréquence et en phase par rapport à la tonalité pilote stéréo afin d'obtenir des données DARC (data) à partir du signal DARC (W).

4. Agencement de circuits de démodulation de signal DARC (100) selon la revendication 3, **caractérisé par** un élément de temps de propagation (186), placé en aval de l'étage de dérivation de signal d'horloge (184), pour retarder le signal d'horloge (psl6) d'un temps de propagation de signal prédéfinissable.

5. Agencement de circuits de démodulation de signal DARC (100) selon une ou plusieurs des revendications précédentes, **caractérisé en ce que** le circuit de réglage de tonalité pilote (101) comprend un étage de génération de signal de commande (154), comprenant

   • un troisième étage multiplicateur (129) pour obtenir un troisième signal de multiplication à partir du signal de transmission multiplex FM (MPX) et de la première oscillation (psl9),
   • un quatrième étage multiplicateur (130) pour obtenir un quatrième signal de multiplication à partir du signal de transmission multiplex FM (MPX) et de la deuxième oscillation (pcl9),

• un cinquième étage multiplicateur (143) pour obtenir un cinquième signal de multiplication à partir du troisième et du quatrième signal de multiplication, et

• un circuit de valeur seuil (146) pour former un signal de commande (u) à partir du cinquième signal de multiplication,

et **en ce que** le circuit de réglage de tonalité pilote (101) comprend en outre un générateur d'oscillations (149) pour former de manière commandée par le signal de commande (u) la première (psl9) et la deuxième (pc19) oscillation au moyen d'une approximation polynomiale.

6. Procédé d'exploitation d'un agencement de circuits de démodulation de signal DARC (100) selon une ou plusieurs des revendications 1 à 5, dans lequel, pour récupérer un signal DARC (W) contenant des données DARC (data) à partir d'un signal de transmission multiplex FM (MPX)

• une première (psl9) et une deuxième oscillation (pcl9), orthogonales l'une à l'autre, synchrones à une tonalité pilote stéréo contenue dans le signal de transmission multiplex FM (MPX) sont obtenues,

• par quadruplement de fréquence, une troisième (ps76) et une quatrième (pc76) oscillation, orthogonales l'une à l'autre, ayant une fréquence quadruplée par rapport à la tonalité pilote stéréo, sont obtenues à partir de la première (psl9) et de la deuxième oscillation (pcl9),

• par multiplication de signal, un premier signal de multiplication est obtenu à partir du signal de transmission multiplex FM (MPX) et de la troisième oscillation (ps76),

• un deuxième signal de multiplication est obtenu à partir du signal de transmission multiplex FM (MPX) et de la quatrième oscillation (pc76),

• par filtrage passe-bas, une première composante de signal DARC (Q) est obtenue à partir du premier signal de multiplication, et

• une deuxième composante de signal DARC (I) est obtenue à partir du deuxième signal de multiplication,

• et le signal DARC (W) étant obtenu à partir d'une modulation de fréquence de la première (Q) et de la deuxième (I) composante de signal DARC.

7. Procédé selon la revendication 6, **caractérisé en ce qu'**à partir de la tonalité pilote stéréo, un signal d'horloge (psl6) est dérivé de manière compensée en fréquence et en phase par rapport à la tonalité pilote stéréo, afin d'obtenir les données DARC (data) à partir du signal DARC (W).

8. Produit de programme informatique comprenant des instructions qui ont pour effet qu'un système composé de l'agencement de circuits de démodulation de signal DARC selon l'une quelconque des revendications 1 à 5 et d'un processeur de signaux exécute le procédé selon l'une quelconque des revendications 6 ou 7.

9. Structure de données lisible par machine, en particulier lisible par ordinateur, générée par un procédé selon au moins l'une des revendications 6 ou 7 et/ou par au moins un produit de programme informatique selon la revendication 8.

10. Support de données lisible par machine, en particulier lisible par ordinateur, sur lequel est enregistré et/ou stocké au moins un produit de programme informatique selon la revendication 8, et/ou sur lequel au moins une structure de données selon la revendication 9 est mise à disposition pour être extraite.

Fig. 1

Fig. 2

EP 3 114 768 B1

# Fig. 3

Fig. 4

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5507024 A
- US 4827515 A

- EP 0627834 A1